# EUROPÄISCHE PATENTSCHRIFT

(11) **EP 1 616 198 B1**
(45) Veröffentlichungstag und Bekanntmachung des Hinweises auf die Patenterteilung: **09.08.2006**
(21) Anmeldenummer: 04721111.5
(22) Anmeldetag: 17.03.2004
(51) Int. Cl.: G01R 31/36, H01M 10/48

(54) **VERFAHREN ZUR ERKENNUNG VON SÄURESCHICHTUNG IN EINER BATTERIE**
METHOD FOR IDENTIFYING ELECTROLYTE STRATIFICATION IN A BATTERY
PROCEDE DE DETECTION D'UNE STRATIFICATION D'ACIDE DANS UNE BATTERIE

(30) Priorität: 11.04.2003 DE 10316638
(43) Veröffentlichungstag der Anmeldung: 18.01.2006
(73) Patentinhaber: ROBERT BOSCH GMBH, 70442 Stuttgart (DE)
(72) Erfinder: RAUCHFUSS, Lutz, 71701 Schwieberdingen (DE)
(86) Internationale Anmeldenummer: PCT/DE2004/000533
(87) Internationale Veröffentlichungsnummer: WO 2004/092757

(56) Entgegenhaltungen:
- DESMETTRE D ET AL: "EXPERIMENTAL STUDY OF STRATIFICATION OF ELECTROLYTE IN LEAD/ACID BATTERIES USED FOR SOLAR ENERGY" 2ND WORLD CONFERENCE ON PHOTOVOLTAIC SOLAR ENERGY CONVERSION. / 15TH EUROPEAN PV SOLAR ENERGY CONFERENCE. / 27TH US IEEE PHOTOVOLTAICSSPECIALISTS CONFERENCE. / 10TH ASIA/PACIFIC PV SCIENCE AND ENGINEERINGCONFERENCE. VIENNA, AUSTRIA, JULY 6 - 10, 1998, Bd. VOL. 2, 6. Juli 1998 (1998-07-06), Seiten 2135-2138, XP001138150 ISBN: 92-828-5419-1
- MATTERA F ET AL: "Characterisation of photovoltaic batteries using radio element detection: the influence and consequences of the electrolyte stratification" JOURNAL OF POWER SOURCES, ELSEVIER SEQUOIA S.A. LAUSANNE, CH, Bd. 113, Nr. 2, 27. Januar 2003 (2003-01-27), Seiten 400-407, XP004402936 ISSN: 0378-7753
- NEWNHAM R H ET AL: "New operational strategies for gelled-electrolyte lead/acid batteries" JOURNAL OF POWER SOURCES, ELSEVIER SEQUOIA S.A. LAUSANNE, CH, Bd. 59, Nr. 1, 4. März 1996 (1996-03-04), Seiten 137-141, XP004044565 ISSN: 0378-7753
- CHAO C W ET AL: "Continuous monitoring of acid stratification during charge/discharge by holographic laser interferometry" JOURNAL OF POWER SOURCES, ELSEVIER SEQUOIA S.A. LAUSANNE, CH, Bd. 55, Nr. 2, 1. Juni 1995 (1995-06-01), Seiten 243-246, XP004044392 ISSN: 0378-7753

## Beschreibung

### Technisches Gebiet

In modernen Kraftfahrzeugen müssen die Energiespeicher zur Versorgung sicherheitskritischer elektrischer Verbraucher, z.B. Break-by-Wire, Steer-by-Wire, Start-Stop-Systeme oder elektrohydraulische Bremssysteme, ständig überwacht und auf ihre Leistungsfähigkeit geprüft werden. Ein elektronisches Batteriemanagementsystem überwacht die Leistungsfähigkeit der Batterien und unterstützt damit entscheidend die bedarfsgerechte Steuerung der Bordnetze. Eine für das Leistungsvermögen einer Batterie maßgebliche Größe ist ihr Ladezustand (SOC-State of Charge). Anhand des SOC-Wertes und des SOH-Wertes (State of Health) wird entschieden, ob bei Bedarf reine Komfort-Funktionen wie Klimaanlage, Radio oder elektrische Fensterheber abzuschalten oder andere Maßnahmen zu ergreifen sind, um sicherheitsrelevante Funktionen wie ABS, ESP oder Bremskraftverstärker aufrechtzuerhalten.

### Stand der Technik

Zur Vorhersage der Leistungsfähigkeit von Batterien sind im Stand der Technik verschiedene Verfahren bekannt. Beispielsweise werden die für das Leistungsvermögen der Batterien maßgeblichen Größen, wie Ladezustand und Batterie-Innenwiderstand durch Auswertung der Ruhespannung sowie Spannungs- und Strommessungen beim Start oder mittels modellbasierter Zustandsbeobachtung bei kontinuierlicher Messung von Spannung, Strom und Temperatur bestimmt, und mit Hilfe dieser Größen eine zu erwartende Leistungsabgabe der Batterie vorausberechnet. Ein solches modellbasiertes Verfahren ist aus DE-A 101 06 508 bekannt. Dabei wird unter anderem der Ladezustand SOC während des Fahrzeugbetriebs kontinuierlich geschätzt, bzw. auf der Grundlage einer abgeschätzten Ruhespannung der Batterie ermittelt.

In Ruhephasen, in denen die Batterie im Wesentlichen unbelastet ist, wird die Ruhespannung gemessen und daraus direkt auf den Ladezustand (SOC) geschlossen.

Folgendes Dokument beschreibt die Entstehung von Säuredichtung in Batterien und offenbart deren Messverfahren und Messvorrichtungen:
DESMETTRE D ET AL: "EXPERIMENTAL STUDY OF STRATIFICATION OF ELECTROLYTE IN LEAD/ACID BATTERIES USED FOR SOLAR ENERGY" 2ND WORLD CONFERENCE ON PHOTOVOLTAIC SOLAR ENERGY CONVERSION. / 15TH EUROPEAN PV SOLAR ENERGY CONFERENCE. / 27TH US IEEE PHOTOVOLTAICSSPECIALISTS CONFERENCE. / 10TH ASIA/PACIFIC PV SCIENCE AND ENGINEERINGCONFERENCE. VIENNA, AUSTRIA, JULY 6 - 10, 1998, Bd. VOL. 2, 6. Juli 1998 (1998-07-06), Seiten 2135-2138, XP001138150 ISBN: 92-828-5419-1.

Problematisch ist dabei auftretende Säureschichtung in der Batterie. Beim Aufladen z.B. einer Blei-Schwefelsäure-Batterie ist die an den Platten entstehende Schwefelsäure schwerer als die umgebende verdünnte Schwefelsäure, so daß sie aufgrund der Gravitation in den unteren Teil der Batterie sinkt. In Ruhephasen ohne Elektrolytbewegung kommt es daher im oberen Bereich der Batterie zur Verringerung und im unteren Bereich zur Erhöhung der Säuredichte. Dies führt zu einem Schwefelsäure-Dichtegradienten, der sogenannten Säureschichtung. Die Säureschichtung sollte nicht permanent erhalten bleiben, da es sonst zu einer irreversiblen Schädigung der Batterie kommt. Ein weiterer Nachteil von Säureschichtung ist, dass in der Ruhephase zu hohe Ruhespannungen gemessen und daher zu hohe Ladezustände (SOC-Werte) ermittelt werden. Folglich wird der momentane Zustand der Batterie zu optimistisch eingeschätzt, so dass sich das die Batterie enthaltende Fahrzeug ggf. nicht mehr starten lässt, obwohl der Ladezustand zuvor als ausreichend hoch ermittelt wurde.

### Darstellung der Erfindung

Ein Vorteil der vorliegenden Erfindung ist, dass die Säureschichtung rechtzeitig erkannt und eine Fehleinschätzung des Ladezustands in der Ruhephase einer Batterie verhindert werden kann. Vorteilhaft ist weiterhin, dass bei erkannter Säureschichtung geeignete Maßnahmen ergriffen werden können, um einerseits trotz Säureschichtung eine richtige Vorhersage der Leistungsfähigkeit der Batterie zu machen und andererseits die Säureschichtung abzubauen.

Diese Vorteile werden erfindungsgemäß erreicht durch ein Verfahren zur Erkennung von Säureschichtung in einer Batterie mit folgenden Schritten:
- Bestimmung eines ersten Ladezustands-Wertes (SOC₁) in einer Belastungsphase der Batterie auf der Grundlage einer abgeschätzten Ruhespannung,
- Bestimmung eines zweiten Ladezustands-Wertes (SOC₂) in einer auf die Belastungsphase folgenden Ruhephase der Batterie auf der Grundlage einer gemessenen Ruhespannung,
- Vergleich des ersten (SOC₁) mit dem zweiten Ladezustands-Wert (SOC₂) und
- Erkennung von Säureschichtung bei Überschreitung einer definierten Abweichung (ΔSOC) des ersten (SOC₁) von dem zweiten Ladezustands-Wert (SOC₂).

Die während der Belastungsphase abgeschätzte Ruhespannung beruht dabei auf einem die Batterie beschreibenden Modell und wird weniger durch die Säureschichtung beeinflusst, insbesondere bei niedrigen Ladezuständen. Die gemessene Ruhespannung in der Ruhephase ist hingegen von Säureschichtung abhängig. Unterscheiden sich die beiden auf der Grundlage dieser Ruhespannungen ermittelten SOC-Werte um mehr als die definierte Abweichung, so wird auf Säureschichtung als Ursache dieses Unterschieds geschlossen.

Üblicherweise wird eine Ruhephase, in der eine Ruhespannungsmessung und Ruhespannungs-Extrapolation stattfindet, so definiert, dass der Ruhestrom (Entladungsstrom der Batterie) kleiner als ein festgelegter Grenzwert ist. Als Belastungsphase, in der eine Abschätzung der Ruhespannung durch ein Modell oder eine SOC-Nachführung durchgeführt wird, zählt eine Phase, in der der Strom größer als ein Grenzwert ist.

Die Batterie ist bei dem erfindungsgemäßen Verfahren eine säurehaltige Batterie, die insbesondere zur Spannungsversorgung eines Kraftfahrzeugs dient. Beispielsweise handelt es sich bei der Batterie um eine Blei-Schwefelsäure-Batterie.

In einer bevorzugten Ausführungsform der Erfindung wird die Abweichung der zwei bestimmten SOC-Werte, bei deren Überschreitung Säureschichtung erkannt wird, als >20 % definiert.

In einer bevorzugten Ausführungsform der vorliegenden Erfindung wird die abgeschätzte Ruhespannung mittels einer Beobachtungseinrichtung, insbesondere eines Kalman-Filters ermittelt, wobei der Kalman-Filter die Ruhespannung auf der Grundlage einer gemessenen Batteriespannung und/oder einer gemessenen Batterietemperatur und/oder eines gemessenen Batteriestroms unter Verwendung eines die Batterie beschreibenden Modells abgeschätzt. Mit Hilfe des Kalman-Filters wird der bei Säureschichtung zu hoch bestimmte Ladezustand bei Ladezuständen <50% erkannt und zu kleineren SOC-Werten hin korrigiert. Das zugrunde liegende Modell ist dabei ein elektrisches Ersatzschaltbild, welches die Batterie beschreibt. Der Kalman-Filter berechnet üblicherweise mit dem Modell die Klemmenspannung der Batterie, vergleicht sie mit dem Messwert und nimmt dann Korrekturen an dem Modell vor, bis Messwert und Schätzwert übereinstimmen.

Gegenstand der vorliegenden Erfindung ist ferner ein Verfahren zur Ermittlung des Ladezustands einer Batterie in einer Ruhephase mit folgenden Schritten:
- Erkennung von Säureschichtung nach dem oben genannten erfindungsgemäßen Verfahren,
- bei Überschreitung der definierten Abweichung (ΔSOC) des ersten (SOC₁) von dem zweiten Ladezustands-Wert (SOC₂), Annahme des ersten Ladezustands-Wertes (SOC₁) für die Ruhephase.

Der erste Ladezustands-Wert, der in der Belastungsphase auf der Grundlage eines Modells abgeschätzt wird, liegt bei auftretender Säureschichtung niedriger als ein in der aktuellen Ruhephase auf der Grundlage der gemessenen Ruhespannung ermittelter SOC-Wert. Durch die Benutzung dieses niedrigeren SOC-Wertes auch für die Ruhephase wird vermieden, dass ein zu hoher Ladezustand angenommen wird und es kann rechtzeitig auf einen zu niedrigen Ladezustand reagiert werden.

Gegenstand der vorliegenden Erfindung ist weiterhin ein Verfahren zur Aufhebung von Säureschichtung in einer Batterie mit folgenden Schritten:
- Erkennung von Säureschichtung nach dem oben genannten erfindungsgemäßen Verfahren,
- bei Überschreitung der definierten Abweichung (ΔSOC) des ersten (SOC₁) von dem zweiten Ladezustands-Wert (SOC₂), Erhöhung einer zur Aufladung der Batterie dienenden Ladespannung.

Durch die Erhöhung der Ladespannung entstehen Gasbläschen im Elektrolyt, die durch ihr Aufsteigen im Elektrolyten für ein Vermischen sorgen und so die Säureschichtung aufheben. Für die Aufhebung der Säureschichtung kann die Ladekennlinie so lange angehoben werden, bis die SOC-Differenzen zwischen Ruhe- und Belastungsphasen wieder kleiner sind. Der Vorteil ist, dass die forcierte Alterung der Batterie mit höheren Ladespannungen und Säureschichtung dann zeitlich begrenzt ist, weil die Ladespannung nach dem Verringern der Säureschichtung wieder abgesenkt wird.

Als alternative oder zusätzliche Gegenmaßnahmen gegen Säureschichtung sind ferner ein Rütteln der Batterie (Fahrbetrieb des Kraftfahrzeugs) oder eine gezielte Elektrolytumwälzung denkbar.

Gegenstand der vorliegenden Anmeldung ist weiterhin die Verwendung der erfindungsgemäßen Verfahren zur Erkennung von Säureschichtung und zur Ermittlung des Ladezustands in einer Anordnung zur Erkennung der Leistungsfähigkeit der Batterie. Durch die Integration der erfindungsgemäßen Verfahren in die Rechenroutinen einer solchen Anordnung, beispielsweise eines Steuergeräts zur Batteriezustandserkennung und zum elektrischen Energiemanagement, wird gewährleistet, dass trotz Säureschichtung der Ladezustand der Batterie richtig ermittelt wird. Das elektrische Energiemanagement (EEM) regelt den gesamten elektrischen Energiehaushalt in einem Kraftfahrzeug. Ein Bestandteil des elektrischen Energiemanagements ist das elektrische Batteriemanagement (EBM). Das EBM umfasst eine Warnanzeige, die dem Fahrer signalisiert, dass ggf. nur noch eine begrenzte elektrische Energie zur Verfügung steht, z.B. für eine elektrohydraulische Bremsanlage. Ferner werden ggf. ausgewählte Verbraucher über ein Relais oder CAN-Bus ausgeschaltet.

Vorzugsweise werden daher die erfindungsgemäßen Verfahren in einem elektrischen Batteriemanagement eingesetzt.

## Patentansprüche

1. Verfahren zur Erkennung von Säureschichtung in einer Batterie **gekennzeichnet durch** die folgenden Schritte:
- Bestimmung eines ersten Ladezustands-Wertes (SOC₁) in einer Belastungsphase der Batterie auf der Grundlage einer abgeschätzten Ruhespannung,
- Bestimmung eines zweiten Ladezustands-Wertes (SOC₂) in einer auf die Belastungsphase folgenden Ruhephase der Batterie auf der Grundlage einer gemessenen Ruhespannung,
- Vergleich des ersten (SOC₁) mit dem zweiten Ladezustands-Wert (SOC₂) und
- Erkennung von Säureschichtung bei Überschreitung einer definierten Abweichung (ΔSOC) des ersten (SOC₁) von dem zweiten Ladezustands-Wert (SOC₂).

2. Verfahren gemäß Anspruch 1, **dadurch gekennzeichnet, dass** die Abweichung (ΔSOC) als >20 % definiert wird.

3. Verfahren gemäß Anspruch 1, **dadurch gekennzeichnet, dass** die abgeschätzte Ruhespannung mittels einer Beobachtungseinrichtung, insbesondere eines Kalman-Filters ermittelt wird, wobei der Kalman-Filter die Ruhespannung auf der Grundlage einer gemessenen Batterie-Spannung und/oder einer gemessenen Batterietemperatur und/oder eines gemessenen Batteriestroms unter Verwendung eines die Batterie beschreibenden Modells abschätzt.

4. Verfahren zur Ermittlung des Ladezustands einer Batterie in einer Ruhephase mit folgenden Schritten:
- Erkennung von Säureschichtung nach einem Verfahren gemäß einem der Ansprüche 1 bis 3,
- bei Überschreitung der definierten Abweichung (ΔSOC) des ersten (SOC₁) von dem zweiten Ladezustands-Wert (SOC₂), Annahme des ersten Ladezustands-Wertes (SOC₁) für die Ruhephase.

5. Verfahren zur Aufhebung von Säureschichtung in einer Batterie mit folgenden Schritten:
- Erkennung von Säureschichtung nach einem Verfahren gemäß einem der Ansprüche 1 bis 3,
- bei Überschreitung der definierten Abweichung (ΔSOC) des ersten (SOC₁) von dem zweiten Ladezustands-Wert (SOC₂), Erhöhung einer zur Aufladung der Batterie dienenden Ladespannung.

6. Verwendung eines Verfahrens gemäß einem der Ansprüche 1 bis 4 in einer Anordnung zur Erkennung der Leistungsfähigkeit der Batterie.

7. Verwendung eines Verfahrens gemäß einem der Ansprüche 1 bis 5 in einem elektrischen Batteriemanagement.

## Claims

1. Method for identification of acid stratification in a battery, **characterized by** the following steps:
- determination of a first state of charge value (SOC₁) in a load phase of the battery on the basis of an estimated rest voltage,
- determination of a second state of charge value (SOC₂) in a rest phase following the load phase of the battery, on the basis of a measured rest voltage,
- comparison of the first (SOC₁) with the second state of charge value (SOC₂) and
- identification of acid stratification if a defined discrepancy (ΔSOC) between the first (SOC₁) and the second state of charge value (SOC₂) is exceeded.

2. Method according to Claim 1, **characterized in that** the discrepancy (ΔSOC) is defined as > 20%.

3. Method according to Claim 1, **characterized in that** the estimated rest voltage is determined by means of an observation device, in particular a Kalman filter, with the Kalman filter estimating the rest voltage on the basis of a measured battery voltage and/or a measured battery temperature and/or a measured battery current, using a model which describes the battery.

4. Method for determination of the state of charge of a battery in a rest phase, having the following steps:
- identification of acid stratification using a method according to one of Claims 1 to 3,
- assumption of the first state of charge value (SOC₁) for the rest phase if the defined discrepancy (ΔSOC) between the first (SOC₁) and the second state of charge value (SOC₂) is exceeded.

5. Method for overcoming acid stratification in a battery having the following steps:
- identification of acid stratification using a method according to one of Claims 1 to 3,
- increasing a charging voltage, which is used to charge the battery, if the defined discrepancy (ΔSOC) between the first (SOC₁) and the second state of charge value (SOC₂) is exceeded.

6. Use of a method according to one of Claims 1 to 4 in an arrangement for identification of the performance of the battery.

7. Use of a method according to one of Claims 1 to 5 for electrical battery management.

## Revendications

1. Procédé de reconnaissance d'une stratification d'acide dans une batterie, **caractérisé par**
les étapes suivantes:
- détermination d'une première valeur d'état de charge (SOC₁) au cours d'une phase de charge de la batterie sur la base d'une tension au repos estimée,
- détermination d'une deuxième valeur d'état de charge (SOC₂) au cours d'une phase de repos succédant à une phase de charge de la batterie, sur la base d'une tension au repos mesurée,
- comparaison de la première (SOC₁) avec la deuxième (SOC₂) valeur d'état de charge, et
- reconnaissance d'une stratification d'acide en cas de dépassement d'un écart prédéterminé (ΔSOC) entre la première (SOC₁) et la deuxième (SOC₂) valeur d'état de charge.

2. Procédé selon la revendication 1,
**caractérisé en ce que**
l'écart (ΔSOC) est défini comme > 20 %.

3. Procédé selon la revendication 1,
**caractérisé en ce que**
la tension au repos estimée est déterminée au moyen d'un dispositif d'observation, en particulier un filtre de Kalman qui estime la tension au repos sur la base d'une tension de batterie mesurée et/ou d'une température de batterie mesurée et/ou d'un courant de batterie mesuré en utilisant un modèle décrivant la batterie.

4. Procédé de détermination de l'état de charge d'une batterie au cours d'une phase de repos, comprenant les étapes suivantes:
- reconnaissance d'une stratification d'acide par un procédé selon l'une quelconque des revendications 1 à 3, et
- en cas de dépassement de l'écart défini (ΔSOC) entre la première (SOC₁) et la deuxième (SOC₂) valeur d'état de charge, acceptation de la première valeur d'état de charge (SOC₁) pour la phase de repos.

5. Procédé de suppression de la stratification d'acide dans une batterie, comprenant les étapes suivantes:
- reconnaissance d'une stratification d'acide par un procédé selon l'une quelconque des revendications 1 à 3, et
- en cas de dépassement de l'écart défini (ΔSOC) entre la première (SOC₁) et la deuxième (SOC₂) valeur d'état de charge, augmentation d'une tension de charge pour la charge de la batterie.

6. Utilisation d'un procédé selon l'une quelconque des revendications 1 à 4, dans un dispositif de reconnaissance de capacité potentielle d'une batterie.

7. Utilisation d'un procédé selon l'une quelconque des revendications 1 à 5, dans une gestion de batterie électrique.
